# EUROPÄISCHE PATENTSCHRIFT

(11) **EP 1 197 127 B1**
(45) Veröffentlichungstag und Bekanntmachung des Hinweises auf die Patenterteilung: **08.12.2010**
(21) Anmeldenummer: 00943945.6
(22) Anmeldetag: 29.06.2000
(51) Int. Cl.: H05G 2/00

(54) **VORRICHTUNG ZUR ERZEUGUNG VON EXTREM-ULTRAVIOLETT- UND WEICHER RÖNTGENSTRAHLUNG AUS EINER GASENTLADUNG**
DEVICE FOR PRODUCING AN EXTREME ULTRAVIOLET AND SOFT X RADIATION FROM A GASEOUS DISCHARGE
DISPOSITIF POUR LA GENERATION D'UN RAYONNEMENT ULTRAVIOLET EXTREME ET D'UN RAYONNEMENT X A FAIBLE ENERGIE A PARTIR D'UNE DECHARGE DANS UN GAZ

(30) Priorität: 29.06.1999 EP 99112403; 22.12.1999 DE 19962160
(43) Veröffentlichungstag der Anmeldung: 17.04.2002
(73) Patentinhaber: Fraunhofer-Gesellschaft zur Förderung der angewandten Forschung e.V., 80686 München (DE)
(72) Erfinder: NEFF, Willi, B-4721 Kelmis (BE); LEBERT, Rainer, B-4721 Kelmis (BE); BERGMANN, Klaus, D-52134 Herzogenrath (DE); ROSIER, Oliver, D-41363 Jüchen (DE)
(86) Internationale Anmeldenummer: PCT/EP2000/006080
(87) Internationale Veröffentlichungsnummer: WO 2001/001736

(56) Entgegenhaltungen:
- EP-A- 0 463 815
- DE-A- 19 753 696
- US-A- 4 771 447
- US-A- 5 175 755
- PATENT ABSTRACTS OF JAPAN vol. 014, no. 545 (M-1054), 4. Dezember 1990 (1990-12-04) & JP 02 230601 A (TOSHIBA CORP), 13. September 1990 (1990-09-13)
- PATENT ABSTRACTS OF JAPAN vol. 013, no. 459 (E-832), 17. Oktober 1989 (1989-10-17) & JP 01 176688 A (LASER-TEC KENKYUSHO:KK), 13. Juli 1989 (1989-07-13)

## Beschreibung

### Technisches Gebiet

Die Erfindung betrifft eine Vorrichtung zur Erzeugung von Extrem-Ultraviolett- und weicher Röntgenstrahlung aus einer Gasentladung nach dem Oberbegriff des Anspruchs 1. Bevorzugtes Anwendungsgebiete sind solche die extreme Ultraviolett-(EUV-) Strahlung oder weiche Röntgenstrahlung im Wellenlängenbereich von ca. 1-20 nm benötigen, und insbesondere um 13 nm, wie zum Beispiel die EUV-Lithografie.

### Stand der Technik

Die DE 28 04 393 C2 offenbart eine Elektrodenanordnung zum Erzeugen und Beschleunigen von geladenen Teilchen bei dem sich mindestens ein Plasmakanal in einem Zwischenraum zwischen den fluchtenden Öffnungen der Elektroden bilden. Die geladenen Teilchen treten aus dem Plasmakanal aus und prallen unter Emission von elektromagnetischer Strahlung auf einen Festkörper. Erzeugt wird sichtbares Licht oder Röntgenstrahlung. Nachteilig bei dieser Lösung ist, dass bei dem in der DE 28 04 393 C2 offenbarten Teilchenbeschleuniger ein verschleißbehafteter abbremsender Festkörper erforderlich ist der die Lebensdauer der Vorrichtung herabsetzt. Weiterhin wird nur bei ca. jedem 10⁻⁴ -ten aufprallenden Teilchen ein Strahlungsquant erzeugt, so dass die Effizienz bei der Strahlungserzeugung niedrig ausfällt.

Die US 4,771,447 lehrt den Einsatz einer zur DE 28 04 393 C2 ähnlichen Elektrodengeometrie, bei der der Raum zwischen den Elektroden evakuiert wird und schubweise Gas eingelassen wird. Bei diesem Gas-Puff-Betrieb entsteht das Plasma überall zwischen den beiden Elektroden und zieht sich dann zu einem einzelnen strahlungsemittierenden Pinchplasmakanal zusammen. Bei dieser Gasentladung wird auf dem rechten Ast der Paschenkurve gearbeitet. Ein Betrieb auf dem linken Ast der Paschenkurve hat hingegen den Vorteil, dass eine Zündung im Gasvolumen und damit besonders verschleißarm möglich ist. Weiterhin kann bei einem Betrieb auf dem linken Ast der Paschenkurve ohne Schaltelement zwischen Strahlungsgenerator und Spannungsversorgung gearbeitet werden, was eine niederinduktive und damit sehr effektive Energieeinkopplung in das Plasma möglich macht. Letzteres ermöglicht wieder bei zeitgemittelt gleicher Energieeinkopplung kleinere Pulsenergien bei höherer Repetitionsrate was ebenfalls den Verschleiß der Elektrodenanordnung mindert. Je nach Erfordernissen erlaubt ein Betrieb auf dem linken Ast der Paschenkurve auch ein Arbeiten bei relativ niedrigen Gasdrücken was zu einer geringeren Strahlungsabsorption in Gasentladungssystem führt. Aus diesen Gründen ist der Gas-Puff als Strahlungsquelle weniger geeignet.

Eine gattungsgemäße Vorrichtung offenbart die DE 197 53 696 A1. Die aus der DE 197 53 696 A1 entnommende **Fig. 1** zeigt eine Elektrodenanordnung mit der Geometrie eines Einkanalpseudofunkenschalters und weist eine Kathode (1) und eine Anode (2) mit einem gasgefüllten Zwischenraum (7) auf. Die beiden Elektroden (1, 2) weisen je eine Öffnung (3, 4) auf durch welche eine Symmetrieachse (5) definiert wird. Bei dieser Elektrodengeometrie kann sich die Gasentladung nicht auf dem kleinsten Weg zwischen den Elektroden ausbreiten, weil in diesem Fall die mittlere freie Weglänge der Ladungsträger größer als der Elektrodenabstand ist. Die Gasentladung sucht sich dann einen längeren Weg, da nur bei ausreichender Entladungsstrecke genügend viele ionisierende Stöße zur Aufrechterhaltung der Entladung möglich sind. Dieser längere Weg ist vorliegend durch die Öffnungen (3, 4) vorgebbar, über welche die Symmetrieachse (5) definiert ist. Dies hat zur Folge, dass sich nur ein einziger Plasmakanal ausbildet, der die oben definierte Symmetrieachse (5) besitzt und dessen seitliche Ausdehnung durch die Bohrlochbegrenzungen bestimmt wird. Bei dieser Gasentladung zündet somit das Plasma innerhalb des durch den Durchmesser der Öffnungen bestimmten Zylinders auf der Symmetrieachse (5). Anschließend zieht sich das Plasma auf einen Zylinder kleineren Durchmessers zusammen. Das in der DE 197 53 696 A1 vorhandene Plasma ist damit ein Kanalpinchplasma, d.h. sowohl in der Zündungsphase als auch später nach dem Zusammenschnüren des Plasmas liegt stets ein Plasma vor, dessen äußere Abmessungen einen Kanal darstellen. Dieses Plasma ist selbst das strahlende Medium. Die Auskopplung der Strahlung erfolgt axial entlang der Symmetrieachse (5) durch die Öffnungen (3, 4) der Hauptelektroden.

Für kommerzielle Zwecke, insbesondere für die EUV-Lithografie, ist eine noch höhere Strahlungsintensität erforderlich als sie die im Stand der Technik bekannten Lösungen leisten. So kann zum Beispiel der Plasmakanal und damit der Elektrodenabstand typischerweise nur wenige Millimeter groß sein wodurch die Intensität der EUV-Strahlungsquelle begrenzt wird. Auch absorbiert das zwingend erforderliche Arbeitsgas im Elektrodenzwischenraum einen nicht zu vernachlässigenden Teil der generierten Strahlung bevor es die Plasmakammer verlässt.

### Darstellung der Erfindung

Die Erfindung ist im Anspruch 1 definiert.

Der Erfindung liegt das technische Problem zugrunde eine Vorrichtung mit einem strahlungsemittierenden Plasma bereitzustellen, mit der eine besonders hohe Strahlungsintensität im EUV-Bereich (Wellenlänge ca. λ=10 bis 20 nm) und im weichen Röntgenwellenlängenbereich (Wellenlänge ca. λ=1 bis 10 nm) erzielt werden kann.

Die Lösung dieses technischen Problems wird durch die im Anspruch 1 angegebenen Merkmale gelöst. Vorteilhafte Ausgestaltungen sind in den Unteransprüchen angegeben. Erfindungsgemäß wurde erkannt, dass sich die genannten Probleme bei Vorrichtungen zur Erzeugung von Extrem-Ultraviolett- und weicher Röntgenstrahlung aus einer Gasentladung lösen lassen, bei denen zwei Hauptelektroden vorgesehen sind zwischen denen sich ein gasgefüllter Zwischenraum befindet, bei der die Hauptelektroden je eine Öffnung aufweisen durch welche eine Symmetrieachse definiert ist, und welche zusätzlich über Mittel zur Erhöhung der Konversionseffizienz verfügen.

Bei Anwendungen die eine hohe abgestrahlte Leistung erfordern, so zum Beispiel die EUV-Lithografie, ist die einkoppelbare elektrische Leistung begrenzt. Daher ist es auch wichtig, wie effizient diese eingekoppelte Energie in Strahlungsenergie umgesetzt bzw. konvertiert wird, d.h. wie hoch die Konversionseffizienz ist. Die dabei interessierende Strahlungsenergie bzw. Strahlung soll ausschließlich diejenige sein, die dem Anwender tatsächlich zur Verfügung steht, die also die Apparatur letztlich verlässt.

Durch nachfolgend beschriebene Mittel zur Erhöhung der Konversionseffizienz kann das Leistungspotential der Gasentladung besser ausgeschöpft und wunschgemäß höhere Strahlungsleistungen erzielt werden. Gewährleistet wird dies primär durch eine Erhöhung der Plasmateilchendichte. Durch alle diese Mittel wird die Strahlungsintensität wunschgemäß erhöht.

Nach einer vorteilhaften Ausgestaltung der erfindungsgemäßen Vorrichtung kann als Mittel zur Erhöhung der Konversionseffizienz mindestens eine Hilfselektrode vorgesehen werden die auf unterschiedliche Art und Weise in der Elektrodenanordnung positioniert werden kann.

Es besteht die Möglichkeit, die Hilfselektrode oder Hilfselektroden hinter den Öffnungen der Hauptelektroden zu positionieren, d.h. auf der dem Zwischenraum abgewandten Seite der Hauptelektrodenöffnungen. So hat es sich als vorteilhaft erwiesen, eine auf positivem Potential liegende Hilfselektrode hinter der negativ geladenen Hauptkathode zu positionieren. Diese Beschaltung bewirkt zunächst eine Erhöhung der Zündfeldstärke bzw. der Zündspannnung der Gasentladung. Da dies gleichzeitig dazu führen würde, dass mehr Energie in die Gasentladung eingekoppelt wird, wird zur Kompensation dieses Effektes eine konstante Zündspannung eingestellt. Die Zündspannung ist nach dem Paschengesetz eine Funktion des Elektrodenabstandes und des Gasdrucks. Daher wird eine konstante Zündspannung dadurch eingestellt, dass bei einem Betrieb der erfindungsgemäßen Vorrichtung auf dem linken Ast der Paschenkurve ein höherer Gasdruck eingestellt wird, weil üblicherweise ein höherer Gasdruck die Zündspannung absenkt. Bei höherem Gasdruck kommt es jedoch zu einer größeren Plasmateilchendichte bzw. es liegen insgesamt mehr Partikel vor die zur Strahlungsemission beitragen. Die erhöhte Strahlungsemission erfolgt dabei bei gleicher in die Gasentladung eingespeister Energie und damit größerer Konversionseffizienz.

Weiterhin ist es möglich, die Hilfselektroden zwischen den Hauptelektroden zu platzieren. Die Hilfselektroden müssen dann eine Öffnung auf der Symmetrieachse aufweisen, weil sich nach dem Zusammenziehen des Plasmas der Plasmakanal auf der Symmetrieachse befindet. Dadurch kann der Abstand der Hauptelektroden vergrößert werden. Die Hilfselektroden verhindern dabei die nicht gewollte Zündung des Plasmas an den Isolatoren zwischen den Hauptelektroden. Damit kann ein deutlich längerer Plasmakanal bis hin zu einigen Zentimeter Länge bereitgestellt werden, und nicht nur von wenigen Millimetern wie bei der DE 197 53 696 A1. Damit kann aber bei axialer Beobachtung, d.h. einer Beobachtung entlang der Symmetrieachse, auch eine um den Faktor 10 höhere Strahlungsintensität zur Verfügung gestellt werden.

Die größere Strahlungsintensität bei längerem Plasmakanal hat ihre Ursache in einer effizienteren Energieumsetzung. Die Elektrodenkonfiguration von zwei Hauptelektroden mit einer oder mehreren dazwischen befindlichen Hilfselektroden kann man sich nämlich gedanklich als Hintereinanderschaltung von zwei oder mehreren einfachen Elektrodenkonfigurationen mit einer Anode, einer Kathode, und einem dazwischen befindlichen Plasma vorstellen. Die Energieumsetzung hängt dabei maßgeblich von der Impedanz ab und ist optimal, wenn die Impedanz des Plasmas etwa gleich der Impedanz des Generators ist. Da die Impedanz einer einfachen Elektrodenanordnung typischerweise deutlich kleiner als die des Generators ist, führt die Nutzung mehrerer hintereinandergeschalteter Elektroden wunschgemäß zu einer größeren Impedanz des Plasmas. Der längere Plasmakanal enthält bedingt durch die bessere Energieumsetzung mehr strahlungsemittierende Partikel was wunschgemäß zu einer größeren Strahlungsintensität führt.

Eine längere strahlungsemittierende Plasmasäule hat weiterhin den Vorteil, dass bei geeigneten Betriebsbedingungen durch stimulierte Emission kohärente Strahlung emittiert wird, was bislang nur von aufwendigen Kapillarentladungen berichtet wird. Für diesen Fall liegt ein Röntgenlaser vor dessen abgestrahlte Strahlungsintensität exponentiell mit der Plasmakanallänge skaliert so dass eine besonders hohe Intensität erzielbar ist.

Die Öffnungen in den Hauptelektroden können unterschiedlich ausgestaltet sein. Zunächst ist es möglich, dass beide Öffnungen durchgehende Öffnungen sind. So kann es sich zum Beispiel bei der jeweiligen Öffnung um ein durchgehendes Loch in Zylinderform handeln was in die jeweilige Elektrode gebohrt wird. Durch die Kathodenöffnung kann dann die Strahlung ausgekoppelt werden.

Allerdings kann bei der Anode auch anstelle einer durchgehenden Öffnung eine Vertiefung gewählt werden, zum Beispiel in Form eines Sacklochs. Die Wahl einer Vertiefung erlaubt eine bessere bzw. einfachere Kühlung der Anode. Die Vertiefung ist dann weniger tief als die Elektrode dick ist. Auch für diesen Fall liegt für die Ausbildung der Gasentladung eine Vorzugsrichtung vor, da die Öffnung auf der Gegenseite, d.h. der Kathode, für die längeren elektrischen Feldlinien sorgt. Die Vertiefung kann zylindersymmetrisch ausgeformt sein oder auch konisch. Bei einer Vertiefung anstelle einer durchgehenden Öffnung steht den Ladungsträgern im Bereich zwischen den Elektroden eine kürzere Strecke zur Verfügung. Dies hat die gleiche Wirkung wie ein kleinerer Elektrodenabstand, d.h. es kommt zu einer Erhöhung der Zündfeldstärke bzw. der Zündspannung. Soll die Zündspannung konstant gehalten werden, so erlaubt dies das Arbeiten bei höheren Gasdrücken was wunschgemäß zu einer höheren Strahlungsausbeute führt. Zusammengefasst besteht bei dieser Ausgestaltung der Vorrichtung das Mittel zur Erhöhung der Konversionseffizienz in einer Vertiefung in der Anode, welche anstelle einer durchgehenden Anodenöffnung gewählt wird.

Gegebenenfalls kann bei der Anode sogar auf die Öffnung völlig verzichtet werden. Dieser Fall kann als Grenzfall einer möglichst kleinen Vertiefung angesehen werden, durch welche die Kühlung optimiert und die Zündfeldstärke maximiert wird.

Nach einer weiteren vorteilhaften Ausgestaltung können Hauptelektroden mit mehreren Öffnungen vorgesehen sein, wobei diese Öffnungen symmetrisch um die Symmetrieachse herum angeordnet werden. In einer einfachsten Anordnung bilden die Öffnungen einen Kreis der seinen Ursprung bzw. sein Zentrum auf der Symmetrieachse der Elektrodenanordnung besitzt. Dies erlaubt es, den Startradius in der Zündungsphase des Plasmas frei vorzugeben was zum Beispiel bei der in der DE 197 53 696 A1 vorgeschlagenen Lösung nur sehr eingeschränkt möglich ist. So bewirkt ein größerer Startradius durch mehrere zusätzliche Öffnungen eine größere Plasmateilchendichte da nach jetzigem Verständnis nur die im durch den Startradius bestimmten Volumen enthaltene Teilchen in den Plasmazustand überführt werden können. Eine einfache Vergrößerung der zentralen Öffnung auf der Symmetrieachse ist hier jedoch nicht geeignet, da dann Untersuchungen zufolge die Zündung der Gasentladung erschwert wird.

Bei Vorhandensein mehrerer Öffnungen in den Elektroden muss wie bei einem Mehrkanalpseudofunkenschalter eine zeitliche Synchronisation bei der Zündung der einzelnen Plasmastränge sichergestellt werden. Hierfür muss zunächst an die Elektroden eine genügend große Haltespannung angelegt werden die im Bereich von einigen Kilovolt bis einigen zehn Kilovolt liegen. Bei einer genügend großen Spannung kommt es durch die bei Gasentladungen allgemein bekannten Mechanismen der Vervielfachung von Ladungsträgern zu einer Gasentladung. Die Zündung erfolgt dabei durch getriggertem Betrieb durch Injektion von Ladungsträgern (Plasma oder Elektronen) in den an die Kathode angrenzenden Raumbereich. Die Zündung selbst erfolgt bei gegebener Elektrodengeometrie bei einem solchen Gasdruck, dass das Produkt aus Elektrodenabstand und Gasdruck auf dem linken Ast der Paschenkurve liegt. Mit den oben erwähnten Hilfselektroden hinter den Öffnungen der Hauptelektroden wird eine gleichzeitige Zündung der Plasmakanäle verbessert. Bei Vorhandensein mehrerer und einander gegenüberliegenden Öffnungen in den Hauptelektroden bilden sich bei gleichzeitiger Zündung zwischen den Öffnungen von Anode und Kathode einzelne Stromfäden aus. Durch den Strompuls (die Strompulse weisen typischerweise Amplituden im zweistelligen Kiloamperebereich auf) bzw. durch das damit verbundene Eigenmagnetfeld werden die einzelnen Stromfäden auf die Symmetrieachse beschleunigt und bilden dort das Pinchplasma mit den äußeren Abmessungen eines zylindersymmetrischen Kanals.

Nach einer weiteren vorteilhaften Ausgestaltung können Hauptelektroden mit je einer einzelnen ringförmigen Öffnung vorgesehen sein. Die beiden Hauptelektroden haben dann neben der Öffnung auf der Symmetrieachse zusätzlich jeweils eine identische kreisförmige Öffnung deren Zentrum bzw. Ursprung auf der Symmetrieachse liegt.

Nach einer weiteren vorteilhaften Ausgestaltung der Erfindung kann zur Steigerung der Konversionseffizienz ein pulsformendes Netzwerk als Stromversorgung vorgesehen sein. Es hat sich nämlich gezeigt, dass sich bedingt durch die Plasmadynamik die elektrischen Eigenschaften der Gasentladung auf einer sehr kurzen Zeitskala von beispielsweise 10 ns ändern. Eine optimale Plasmadynamik kann dabei durch maßgeschneiderte Strompulse realisiert werden, d.h. Strompulse mit einer gezielt einstellbaren Länge, Stromanstiegszeit, Form etc.. Wird als Stromversorgung nur eine Kondensatorbank eingesetzt, so lassen sich bei der sich einstellenden gedämpften Schwingung nur zwei Parameter, nämlich die Stromamplitude und die Periodendauer einstellen. Bei einem pulsformenden Netzwerk hingegen lassen sich die Pulseigenschaften gezielter und präziser einstellen. Die sich damit einstellende bessere Plasmadynamik führt wunschgemäß zu einer besseren Umsetzung der in die Gasentladung eingespeisten elektrischen Energie in Strahlungsenergie, also zu einer höheren Konversionseffizienz.

Gleichfalls vorteilhaft ist der Einsatz eines pulsformenden Netzwerkes für den Fall, dass die Spannungsanstiegszeit optimiert werden soll. Die Spannungsanstiegszeit ist die Zeit die benötigt wird, um die Spannung an den Elektroden auf einen Sollwert ansteigen zu lassen. Ist die Spannungsanstiegszeit kürzer als die Durchbruchszeit der Gasentladung, also kürzer als die Zeit zwischen Anlegen der Spannung und Einsetzen des Stromflusses, so erfolgt die Zündung bei einer Spannung die größer ist als die Zündspannung. Dies wiederum erlaubt es wie bei den eingangs erwähnten Hilfselektroden hinter den Öffnungen der Hauptelektroden mit einem höheren Gasdruck zu arbeiten was zu einer höheren Strahlungsintensität führt.

Eine mögliche Realisierung des pulsformenden Netzwerkes besteht darin, zusätzlich zur Kondensatorbank, über die die Hauptelektroden direkt angeschlossen sind, einen oder mehrere weitere Kondensatoren vorzusehen. Diese zusätzlichen Kondensatoren werden über einen oder mehrere sättigbare magnetische Schalter angeschlossen. Durch einen geeigneten Einsatz dieser Schalter kann weiterhin zum Beispiel kurz vor der Aufbauphase des Pinchplasmas, und damit vor der Strahlungsemission, zusätzliche Energie in das Plasma eingekoppelt werden. Auch hierdurch kann dem Anwender dieser Strahlungquelle mehr Strahlungsleistung zur Verfügung gestellt werden.

Eine weitere Maßnahme zur Steigerung der Konversionseffizient besteht darin, dass neben der Gaseintritts- und Gasauslassöffnung für das Arbeitsgas im Elektrodenzwischenraum mindestens eine zusätzliche Gaseinlassöffnung vorgesehen ist. Üblicherweise wird die Strahlungsquelle bei quasistationärem Gasfluss bei Drücken von wenigen Pascal auf dem linken Ast der Paschenkurve betrieben. Der quasistationäre Gasfluss stellt sicher, dass praktisch überall in dem Elektrodenssystem der gleiche Druck herrscht. Durch das Vorhandensein von mindestens einer weiteren Gaseinlass- oder Gasaustrittsöffnung kann an den betreffenden Stellen im Elektrodensystem systematisch Gas eingelassen oder abgepumpt werden. Dadurch ist es auch möglich, in unterschiedliche Raumbereiche der Elektrodenanordnung unterschiedliche Gase vorzusehen. So kann zum Beispiel im Bereich des Plasmakanals auf der Symmetrieachse ein oder mehrere Gase mit hohen Kernladungszahlen vorgesehen sein, zum Beispiel Xenon, Neon, Sauerstoff oder einfach Raumluft. Bei diesen schweren Gase bilden sich bei ihrer Überführung in den Plasmazustand Spezies mit elektromagnetischen Übergängen im hier interessierenden Spektralbereich von λ=1 bis 20 nm. In anderen Raumbereichen, und insbesondere im Raumbereich zwischen dem Plasmakanal und dem Strahlaustrittsfenster, kann dann ein leichtes Gas wie zum Beispiel Helium oder Deuterium vorgesehen sein. Die leichten Gase absorbieren die erzeugte Strahlung jedoch besonders gering, so dass dem Anwender eine besonders hohe Strahlungsintensität zur Verfügung steht.

Ein weiterer Vorteil weiterer bzw. zusätzlicher Öffnungen zum Einlassen und Abpumpen von Gasen besteht darin, dass damit im Plasmakanalbereich leichter eine höhere Plasmateilchendichte erzielt werden kann. Beispielsweise kann dies dadurch erfolgen, dass dem Hauptgas Xenon im Bereich zwischen den zentralen Öffnungen auf der Symmetrieachse der Anordnung zusätzlich Helium zugemischt wird. Durch diese homogene Gasmischung in diesem Raumbereich kann die Zündspannung zu für die Plasmaemission höheren Werten bei höherer Gasdichte verändert werden.

In einer weiteren Ausgestaltung der erfindungsgemäßen Vorrichtung sind zentrale Öffnungen (3, 4) der Hauptelektroden (1, 2) vorgesehen, deren Öffnungen auf der der Plasmakammer abgewandten Seite größer sind als auf der Seite, welcher dem gasgefüllten Zwischenraum zugewandt ist. Dabei ist es auch möglich, dass nur eine der beiden Öffnungen derart bemessen ist. Wegen der Zylindersymmetrie des Pinchplasmakanals auf der Symmetrieachse ist es dabei vorteilhaft, dass auch die Öffnung bzw. die Öffnungen zylindersymmetrisch mit gleicher Symmetrieachse sind. Daher können diese zentralen Elektrodenöffnungen konisch bzw. in Form eines Kegelstumpfes geformt sein, wobei die Kegelstumpfspitze der Plasmakammer zugewandt ist. Mit den konischen Öffnungen kann ebenfalls eine Steigerung der Konversionseffizienz erzielt werden.

Die Steigerung der Konversionseffizienz durch eine derartige Wahl der zentralen Elektrodenöffnungen liegt daran, dass es durch diese möglich ist, mehr Strahlung auszukoppeln, als dass dies bei einer typischerweise zylindersymmetrischen Öffnung möglich ist. In Experimenten wurde eine zylindersymmetrische Öffnung mit einem Durchmesser von 10 mm gewählt, wobei man als Beobachter bei der gegebenen Dicke der Elektroden das Plasma noch unter einem Winkel von ca. 14° gegenüber der Symmetrieachse sehen konnte. Wurde im Experiment eine konische Öffnung gewählt, so konnte man das Plasma noch unter einem Winkel von 60° erkennen. Damit ergab sich bei gleicher in das Plasma eingespeister Energie eine ausgekoppelte Strahlungsintensität, die gegenüber dem Fall der zylindersymmetrischen Öffnung etwa um den Faktor 20 größer war.

Ein weiterer Vorteil der konischen Öffnungen besteht darin, dass bei konstantem Raumwinkel diese auch die Wahl dickerer Elektroden zulassen. Da die Elektroden während des Betriebes gekühlt werden ist die Kühlung dickerer Elektroden leichter zu bewerkstelligen als mit dünnen Elektroden. Die bessere Kühlung wiederum erlaubt eine größere Energieeinspeisung, wodurch eine Optimierung der Elektrodenkonfiguration zu höheren Leistungen möglich ist.

In einer weiteren Ausführungsform der erfindungsgemäßen Vorrichtung sind zwischen dem gasgefüllten Zwischenraum (7) und den im Ultrahochvakuum (UHV) befindlichen Teilen der Vorrichtung ein oder mehrere Systeme aus Kapillaren zur Vakuumtrennung vorgesehen. Kapillaren weisen aufgrund ihrer im Vergleich zum Durchmesser großen Länge einen hohen Strömungswiderstand für Gase auf, so dass ein hoher Druckabfall erreicht werden kann. Durch die Kapillaren kann daher ein besonders hohes Ultrahochvakuum geschaffen werden wodurch die Strahlungsabsorption in diesen Teilen der Vorrichtung reduziert wird. Bei gleicher in das System eingekoppelten Energie führt dies wunschgemäß zu einer größeren Strahlungsintensität für die jeweilige Applikation.

Eine mögliche Realisierung für ein System von Kapillaren ist die Mikrokanalplatte. Mikrokanalplatten weisen hohle Kanäle auf, durch die die Strahlung vom Zwischenraum (7) in den UHV-Bereich (19) und von dort zur Applikation gelangen kann. Selbst dünne Mikrokanalplatten sind sehr stabil und zeigen eine hohe Transmission für die erzeugte EUV-Strahlung. So kann die Mikrokanalplatte je nach Geometrie des Elektrodensystems als zylinderförmige Scheibe ausgestaltet sein. Mikrokanalplatten sind mit Kanälen mit Durchmesser im ein- bis zweistelligen Mikrometerbereich durchzogen. So ist es zum Beispiel möglich, Mikrokanalplatten mit Dicken im einstelligen Millimeterbereich zu wählen, deren Oberfläche zu mindestens 50%, vorzugsweise zu mindestens 70%, aus den Öffnungen der Mikrokanäle besteht.

Es ist weiterhin möglich, eine geometrisch-räumliche Anordnung von Kapillaren zu wählen, mit der die Strahlung von der Plasmaquelle aufgesammelt, geformt und geeignet in das optische System der jeweiligen Anwendung eingekoppelt werden kann. Ein Beispiel für ein solches System ist die Kumakhov-Linse.

Nachfolgend soll die erfindungsgemäße Strahlungsquelle anhand von Ausführungsbeispielen erläutert werden. Es zeigen:

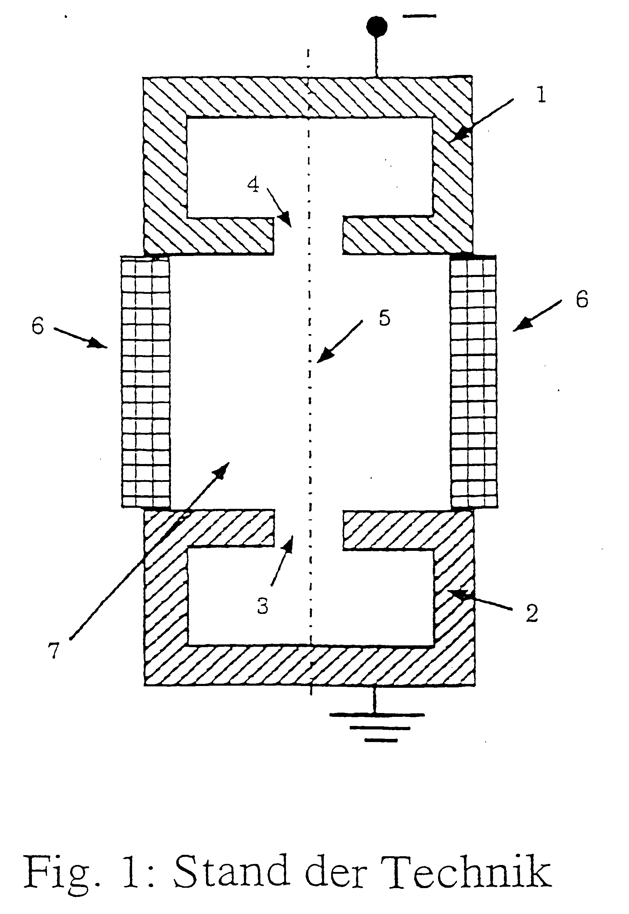

- **Fig. 1:**: Elektrodengeometrie nach dem Stand der Technik
- **Fig. 2:**: Elektrodenkonfiguration mit Hilfselektroden
- **Fig. 3:**: Elektrodenkonfiguration mit zusätzlichen Gaseinlassöffnungen
- **Fig. 4:**: Elektrodenkonfiguration mit zusätzlichen Öffnungen
- **Fig. 5:**: Elektrode mit ringförmiger Zusatzöffnung

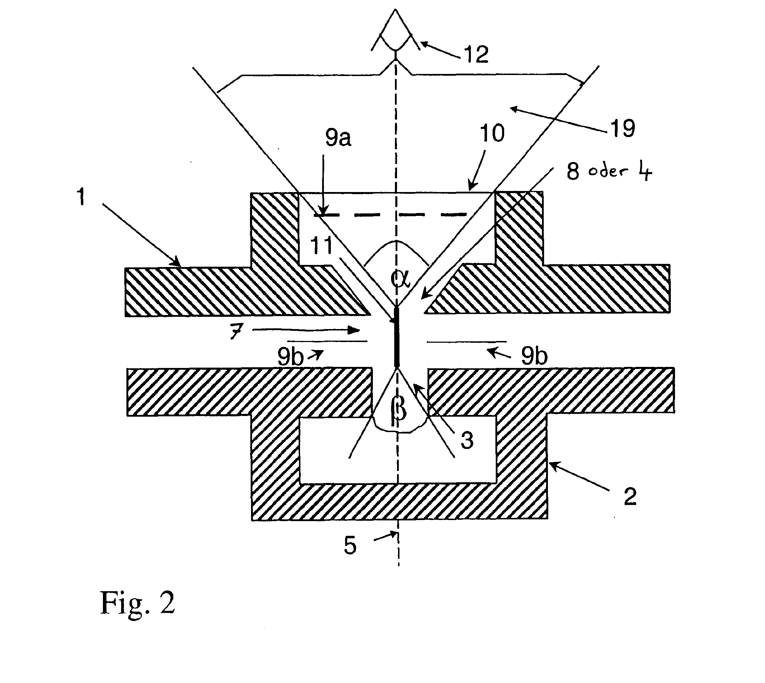

**Fig. 2** zeigt die erfindungsgemäße Vorrichtung mit zusätzlichen mit Hilfselektroden (9a, 9b) zur Steigerung der Konversionseffizienz bzw. der Strahlungsausbeute. Zwischen den spannungsbeaufschlagten Elektroden (1, 2) bildet sich im gasgefüllten Zwischenraum (7) ein die Strahlung emittierendes Pinchplasma (11) aus. Auf der dem Zwischenraum (7) abgewandten Seite der Kathode (1) befindet sich eine Hilfselektrode (9a) durch welche sich die Zündfeldstärke der Gasentladung steigern lässt. Dies wiederum erlaubt den Betrieb bei höheren Gasdrücken bei größerer Strahlungsausbeute. Die Hilfselektrode (9a) weist im Betrieb ein positives Potential gegenüber der Kathode (1) auf. Zwischen den Hauptelektroden befindet sich ferner eine Hilfselektrode (9b) zur Bereitstellung einer längeren Pinchplasmasäule (11).

Untersuchungen zeigten, dass die Plasmasäule (11) nicht oder nur gering in die Öffnungen (3, 8) der Hauptelektroden hereinragt, und dass damit bei einer zylindersymmetrischen Ausführung der Öffnungen für die Strahlungsauskopplung nur ein geringer Raumwinkel zur Verfügung steht. So weist die zylindersymmetrische Öffnung (3) bei dieser Ausführungsform einen Durchmesser von 10 mm auf, womit ein Beobachter bei der gegebenen Dicke der Elektroden das Plasma noch unter einem Winkel von α=14° gegenüber der Symmetrieachse (5) sehen könnte. Zur Erhöhung der Strahlungsausbeute wurde daher die Öffnung (8) konisch ausgeführt. Bei der konisch ausgeführten Öffnung (8) kann das Plasma (11) noch unter einem Winkel von β=60° gegenüber der Symmetrieachse (5) vom Beobachter (12) erkannt werden. Damit ergibt sich bei gleicher in das Plasma eingespeister Energie eine ausgekoppelte Strahlungsintensität, die gegenüber dem Fall der zylindersymmetrischen Öffnung etwa um den Faktor 20 größer ist.

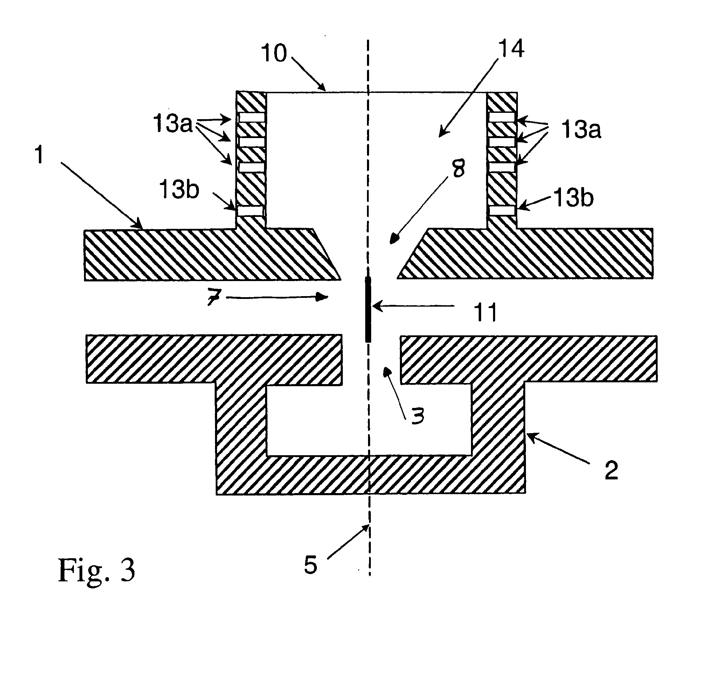

**Fig. 3** zeigt prinzipiell die gleiche Elektrodenkonfiguration wie in **Fig. 2**, jedoch ohne Hilfselektroden. Zusätzlich sind Hilfsöffnungen (13a, 13b) für den Gasein- und/oder Gasaustritt aus den Bereich (14) der Hohlkathode (1) vorgesehen. So kann über die Öffnungen (13b) das für die Gasentladung erforderliche Entladegas wie zum Beispiel Xenon, Sauerstoff oder SF₆ eingelassen werden das im Zwischenraum (7) gezündet wird. In den in **Fig. 3** nicht gezeigten rückwärtigen Bereichen des Elektrodensystems befindet sich ein Gas mit geringer Absorption wie Helium oder Wasserstoff. Dieses für die erzeugte Strahlung transparente Gas wird über die Öffnungen (13a) in den Bereich (14) eingelassen. Hierbei sind die Öffnungen (13a) für den Einlass des transparenten Gases weiter von der Öffnung (8) entfernt als die Öffnungen (13b) für den Einlass des Entladegases. Damit befindet sich zunächst in dem dem Strahlaustrittsfenster (10) zugewandten Teil des Bereichs (14) der Kathode (1) das leichte Gas, und in dem dem Schutzglas (10) abgewandten Teil des Bereichs (14), bzw. in der Nähe der Öffnung (8), das schwerere Entladegas.

Bei dieser Vorgehensweise bestehen nun zwei Möglichkeiten. Zum einen können beide Gase über nicht in **Fig. 3** eingezeichneten Öffnungen im Bereich des gasgefüllten Zwischenraums (7) so abgesaugt werden, dass es zur Durchmischung der beiden Gasarten kommt. Dies hat den Vorteil, dass im Elektrodenzwischenraum (7) befindlichen Plasmakanal eine höhere Plasmateilchendichte erzielt werden kann. Alternativ kann ein Teil der Öffnungen (13a) durch Einstellen einer laminaren Strömung des leichten Gases in den rückwärtigen Bereichen der Elektrodensystems so genutzt werden, dass über ein Absaugen des leichten Gases eine Durchmischung weitestgehend vermieden wird. Damit verbleibt das leichte Gas dauerhaft in dem dem Strahlaustrittsfenster (10) zugewandten Teil des Bereichs (14). Dieses leichte Gas absorbiert die Strahlung jedoch erheblich geringer als das Entladegas, so dass dem Anwender wunschgemäß eine größere Strahlungsleistung zur Verfügung steht.

Eine weitere Möglichkeit zur Nutzung der Öffnungen (13a, 13b) besteht darin, das Entladegas nicht über die Öffnungen (13b), sondern über nicht in **Fig. 3** gezeigte Öffnungen im Bereich des gasgefüllten Zwischenraums (7) oder der Anode (2) einzulassen und über die Öffnungen (13b) abzusaugen. Das leichte bzw. transparente Gas wird wieder über die Öffnungen (13a) eingelassen. Diese Ausführungen zeigen, dass die Öffnungen (13a) sowohl zum Gaseinlass als auch zum Gasauslass des oder der Entladegase eingesetzt werden können, und die Öffnungen (13a) nur zum Gaseinlass des oder der leichten Gase.

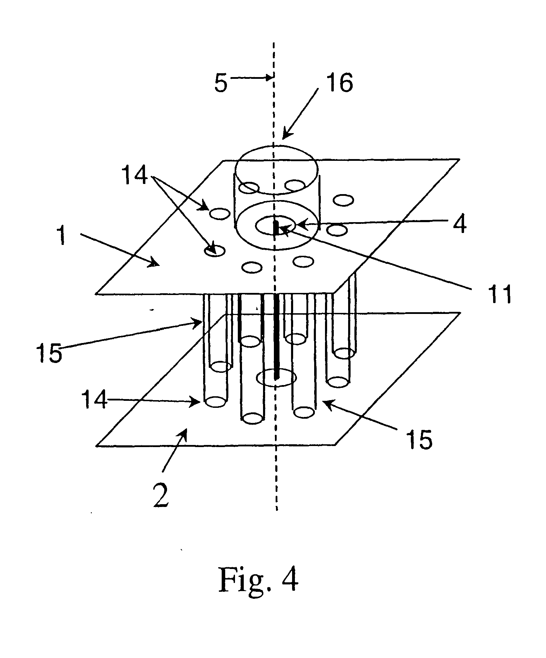

**Fig. 4** zeigt eine Ausführungsform der erfindungsgemäßen Vorrichtung, bei der die Elektroden (1, 2) zusätzliche kreisförmigen Öffnungen (14) aufweisen. Die Öffnungen (14) sind dabei innerhalb der jeweiligen Elektrode kreisförmig und bezogen auf die Kreislinie äquidistant angeordnet. Anode (1) und Kathode (2) weisen dabei eine gleiche Anzahl gleich ausgeführter Öffnungen in der gleichen geometrischen Anordnung bezogen auf die Symmetrieachse (5) auf. Durch diese Ausgestaltung gibt es bei einer Blickrichtung entlang der Symmetrieachse (5) zu jeder Öffnung (4) in der Anode (2) eine dahinterliegende Öffnung in der Kathode (1). Bei Anlegen einer Spannung an die Elektroden kommt es in der Zündungsphase der Gasentladung zur Herausbildung mehrerer Plasmafäden (15). Die Plasmafäden (15) ziehen sich nachfolgend aufgrund des Eigenmagetfeldes des fließenden elektrischen Stromes zu einem einzigen zentralen strahlungsemittierenden Pinchplasmakanal (11) auf der Symmetrieachse (5) zusammen. Die Auskopplung der Strahlung erfolgt axial entlang der Symmetrieachse (5). Ist die dem Strahlaustrittsfenster zugewandte Elektrode die Kathode (1), so ist es günstig, zwischen der zentralen Öffnung (4) und den Zusatzöffnungen (14) eine Abschirmung (16) vorzusehen. Die Abschirmung (16) hat den Vorteil, dass damit eine Zündung erleichtert wird, die nur in den Kanälen der dünnen Plasmafäden (15), nicht aber im zentralen Kanal entlang der Symmetrieachse (5) erfolgt. Auf die Abschirmung (16) kann verzichtet werden, wenn die dem Strahlaustrittsfenster (10) zugewandte Elektrode die Anode (2) ist, da eine Zündung nur auf der Kathodenseite erfolgt.

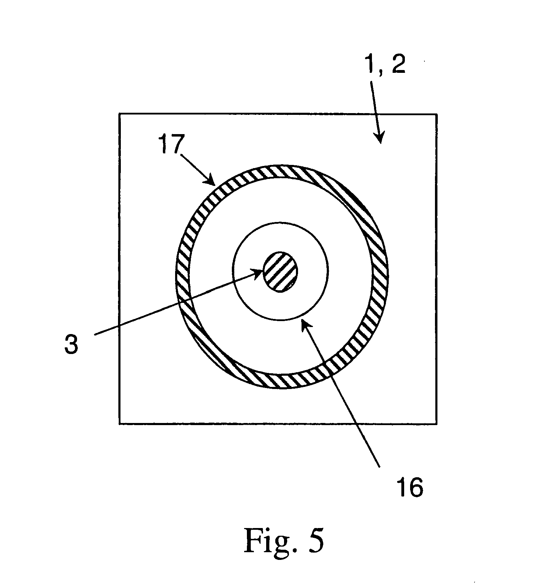

**Fig. 5** zeigt ferner in einer Aufsicht eine Elektrode mit zentraler Öffnung (3), die zusätzlich eine ringförmige Öffnung (17) aufweist. Die ringförmige Öffnung (17) weist ein Zentrum bzw. eine Symmetrieachse auf, welche mit der Symmetrieachse (5) der Elektrodenkonfiguration zusammenfällt. Eine dem Strahlaustrittsfenster (10) zugewandte Elektrode dieser Ausführung erfordert wie bei der Ausführungsform nach **Fig. 4** eine zusätzliche Abschirmung (16).

### Bezugszeichenliste:

- 1:: Kathode
- 2:: Anode
- 3, 4:: (Haupt-) Öffnung
- 5:: Symmetrieachse
- 6:: Isolator als Abstandshalter
- 7:: gasgefüllter Zwischenraum
- 8:: konisch ausgeführte Öffnung
- 9a:: Hilfselektrode hinter der Öffnung der Hauptelektrode
- 9b:: Hilfselektrode zwischen den Hauptelektroden
- 10:: Strahlaustrittsfenster
- 11:: Pinchplasma
- 12:: Beobachter
- 13a, 13b:: Gaseintritts- und/oder Gasaustrittsöffnung
- 14:: zusätzliche Öffnung in der Elektrode
- 15:: Plasmafaden
- 16:: Abschirmung
- 17:: ringförmige Öffnung
- 19:: Ultrahochvakuum- (UHV-) Bereich der Vorrichtung

## Patentansprüche

1. Vorrichtung zur Erzeugung von Extrem-Ultraviolett-und weicher Röntgenstrahlung aus einer Glasentladung, aus einer auf dem linken Ast der Paschenkurve betriebenen Gasentladung, bei der zwei Hauptelektroden (1, 2) vorgesehen sind, zwischen denen sich ein gasgefüllter Zwischenraum (7) befindet, bei der die Hauptelektroden (1, 2) je eine Öffnung (3, 4) aufweisen, durch welche eine Symmetrieachse (5) definiert ist, und bei der die Elektroden so geformt sind, dass sich die Gasentladung ausschließlich in dem durch die fluchtenden Öffnungen bestimmten Volumen ausbildet, und bei dem der auf der Symmetrieachse entstehende Plasmakanal Quelle für die EUV- und/oder Röntgenstrahlung ist,
**dadurch gekennzeichnet,**
**dass** als Mittel zur effizienteren Konversion der eingekoppelten elektrischen Energie in Strahlungsenergie eine Hilfselektrode (9b) zwischen den Hauptelektroden (1, 2) vorhanden ist, welche eine Öffnung auf der Symmetrieachse (5) aufweist.

2. Vorrichtung nach Anspruch 1, **dadurch gekennzeichnet, dass** mindestens eine der Hauptelektrodenöffnungen (3, 4) auf der dem Zwischenraum (7) abgewandten Seite größer ausgeführt ist als auf der dem Zwischenraum (7) zugewandten Seite.

3. Vorrichtung nach Anspruch 2, **dadurch gekennzeichnet, dass** die Hauptelektrodenöffnungen (3, 4) kegelstumpfförmig ausgeführt sind.

4. Vorrichtung nach einem der Ansprüche 1 bis 3, **dadurch gekennzeichnet, dass** eine Hilfselektrode (9a) in Strahlaustrittsrichtung hinter der Öffnung (4), nämlich auf der dem Zwischenraum (7) abgewandten Seite der Öffnung (4) einer der Hauptelektroden (1) vorhanden ist.

5. Vorrichtung nach einem der Ansprüche 1 bis 4, **dadurch gekennzeichnet, dass** beide Hauptelektroden (1,2) mehrere Öffnungen (14) aufweisen.

6. Vorrichtung nach Anspruch 5, **dadurch gekennzeichnet, dass** die Öffnungen (14) in den Hauptelektroden (1, 2) auf einem Kreis angeordnet sind, durch dessen Zentrum die Symmetrieachse (5) verläuft.

7. Vorrichtung nach mindestens einem der Ansprüche 1 bis 4, **dadurch gekennzeichnet, dass** beide Hauptelektroden (1, 2) eine ringförmige Öffnung (17) aufweisen, wobei das Zentrum des Rings auf der Symmetrieachse (5) liegt.

8. Vorrichtung nach mindestens einem der Ansprüche 1 bis 7, **dadurch gekennzeichnet, dass** ein pulsformendes Netzwerk als Spannungsversorgung vorhanden ist.

9. Vorrichtung nach mindestens einem der Ansprüche 1 bis 8, **dadurch gekennzeichnet, dass** neben der Gasein- und auslassöffnung für das Arbeitsgas im Elektrodenzwischenraum (7) mindestens eine zusätzliche Gaseinlass- oder Gasaustrittsöffnung (13a, 13b) vorhanden ist.

10. Vorrichtung nach mindestens einem der Ansprüche 1 bis 9, **dadurch gekennzeichnet, dass** in einem Bereich (19) außerhalb des gasgefüllten Zwischenraumes (7) in Strahlaustrittsrichtung ein System von Kapillaren zur Vakuumtrennung vorhanden ist.

11. Vorrichtung nach Anspruch 10, **dadurch gekennzeichnet, dass** das System von Kapillaren eine Mikrokanalplatte oder eine Kumakhov-Linse ist.

## Claims

1. Device for generating extreme ultraviolet and soft x-ray radiation from a gas discharge, operated on the left-hand branch of the Paschen curve, comprising two main electrodes (1, 2), between which there is a gas-filled space (7), wherein each of said main electrodes exhibits an opening (3, 4), defining an axis of symmetry (5), and wherein the electrodes are formed in such a manner that the gas discharge forms exclusively in the volume determined by an alignment of the openings, and where the plasma channel, generated on the axis of symmetry, is the source of the extreme ultraviolet and soft x-ray radiation, **characterized in that** as a means for more efficient conversion of the injected electrical energy into radiation energy, an auxiliary electrode (9b) is provided between the main electrodes (1, 2), which exhibits an opening on the axis of symmetry (5).

2. Device according to claim 1, **characterized in that** at least one of the openings (3, 4) of the main electrodes on the side facing away from the space (7) is larger than on the side facing the space (7).

3. Device according to claim 2, **characterized in that** the openings (3, 4) of the main electrodes exhibit the shape of a truncated cone.

4. Device according to one of the claims 1 to 3, **characterized in that** an auxiliary electrode (9a) is provided in direction of radiation emission behind the opening (4) of one of the main electrodes (1), namely on the side of the opening (4) of one of the main electrodes (1) facing away from the space (7).

5. Device according to one of the claims 1 to 4, **characterized in that** both main electrodes (1, 2) each have a plurality of openings (14).

6. Device according to claim 5, **characterized in that** the openings (14) in the main electrodes (1, 2) are arranged on a circle, through whose centre runs the axis of symmetry (5).

7. Device according to at least one of the claims 1 to 4, **characterized in that** both main electrodes (1, 2) have a ring-shaped opening (17), whereby the centre of the ring lies on the axis of symmetry (5).

8. Device according to at least one of the claims 1 to 7, **characterized in that** a pulse-forming network is provided as a power supply.

9. Device according to at least one of the claims 1 to 8, **characterized in that** in addition to the gas inlet and outlet opening for the working gas in the electrode space (7), there is at least one additional gas inlet or outlet opening (13a, 13b).

10. Device according to at least one of the claims 1 to 9, **further comprising** a system of capillaries for vacuum separation provided in an area (19) outside of the gas-filled space (7) in direction of radiation emission.

11. Device according to claim 10, **characterized in that** the system of capillaries is a micro channel plate or a Kumakhov lens.

## Revendications

1. Dispositif destiné à générer un rayonnement ultraviolet extrême et des rayons X mous à partir d'une décharge dans un gaz, notamment à partir d'une décharge dans un gaz produite sur la branche gauche d'une courbe de Paschen, dans lequel deux électrodes principales (1, 2) sont prévues, entre lesquelles se trouve un espace intermédiaire rempli de gaz, dans lequel les électrodes principales comprennent chacune une ouverture (3), au travers desquelles un axe de symétrie (5) est défini, et dans lequel les électrodes sont façonnées de telle sorte que la décharge dans un gaz se produit exclusivement dans le volume déterminé par les ouvertures en alignement, et dans lequel le canal de plasma formé sur l'axe de symétrie est une source de rayonnement UV extrême ou de rayons X, **caractérisé en ce qu'**il comprend une électrode auxiliaire (9b) se trouvant entre les deux électrodes principales (1, 2) et comportant une ouverture sur l'axe de symétrie (5) qui sert à convertir plus efficacement l'énergie électrique injectée en énergie de rayonnement.

2. Dispositif selon la revendication 1, **caractérisé en ce qu'**au moins l'une des ouvertures d'électrodes principales (3) est conçue de façon à être plus grande sur le côté opposé à l'espace intermédiaire (7) que sur le côté apposé à l'espace intermédiaire (7).

3. Dispositif selon la revendication 2, **caractérisé en ce que** les ouvertures d'électrodes principales (3) sont conçues en forme de cône tronqué.

4. Dispositif selon l'une quelconque des revendications 1 à 3, **caractérisé en ce qu'**une électrode auxiliaire (9a) est disposée dans le sens de la sortie du rayonnement derrière l'ouverture, c'est-à-dire sur le côté de l'ouverture d'une des électrodes principales (1) opposé à l'espace intermédiaire (7).

5. Dispositif selon l'une quelconque des revendications 1 à 4, **caractérisé en ce que** les deux électrodes principales (1,2) comportent plusieurs ouvertures (14).

6. Dispositif selon la revendication 5, **caractérisé en ce que** les ouvertures (14) dans les électrodes principales (1,2) sont disposées sur un cercle, l'axe de symétrie (5) passant par le centre du cercle.

7. Dispositif selon au moins l'une quelconque des revendications 1 à 4, **caractérisé en ce que** les deux électrodes (1, 2) comprennent une ouverture annulaire (17), le centre de l'anneau étant situé sur l'axe de symétrie (5).

8. Dispositif selon au moins l'une quelconque des revendications 1 à 7, **caractérisé en ce qu'**un réseau de mise en forme d'impulsions est utilisé à titre d'alimentation électrique.

9. Dispositif selon au moins l'une quelconque des revendications 1 à 8 **caractérisé en ce qu'**au moins une entrée ou une sortie de gaz complémentaire (13a, 13b) est prévue à côté de l'ouverture d'entrée et de sortie de gaz pour le gaz de travail dans l'espace intermédiaire entre les électrodes (7),

10. Dispositif selon au moins l'une quelconque des revendications 1 à 9, **caractérisé en ce qu'**un système de capillaires destiné à faire le vide est disposé dans une zone (19) à l'extérieur de l'espace intermédiaire (7) rempli de gaz dans le sens de la sortie du rayonnement.

11. Dispositif selon la revendication 10, **caractérisé en ce que** le système de capillaires est une plaque à microcanaux ou une lentille de Kumakhov.
